(19) Europäisches Patentamt
European Patent Office
Office européen des brevets

(11) Veröffentlichungsnummer: **0 471 151 B1**

(12) **EUROPÄISCHE PATENTSCHRIFT**

(45) Veröffentlichungstag der Patentschrift: **07.09.94**

(51) Int. Cl.[5]: **C08G 18/64**, C08G 18/81, C08F 299/06, C08G 18/62

(21) Anmeldenummer: **91107450.8**

(22) Anmeldetag: **08.05.91**

(54) **Durch Strahlung vernetzbare Bindemittelgemische.**

(30) Priorität: **14.08.90 DE 4025687**

(43) Veröffentlichungstag der Anmeldung:
**19.02.92 Patentblatt 92/08**

(45) Bekanntmachung des Hinweises auf die Patenterteilung:
**07.09.94 Patentblatt 94/36**

(84) Benannte Vertragsstaaten:
**AT BE CH DE DK ES FR GB GR IT LI LU NL SE**

(56) Entgegenhaltungen:
**EP-A- 0 194 360**
**EP-A- 0 318 962**
**FR-A- 2 245 726**
**FR-A- 2 359 190**

(73) Patentinhaber: **RÜTGERSWERKE AKTIENGESELLSCHAFT**
**Mainzer Landstrasse 217**
**D-60326 Frankfurt (DE)**

(72) Erfinder: **Grundke, Ulrich**
**Bronkhorststrasse 52**
**W-4100 Duisburg 12 (DE)**
Erfinder: **Liebetanz, Klaus-Peter**
**Varzinerstrasse 7**
**W-4100 Duisburg 12 (DE)**
Erfinder: **Hansen, Achim, Dr.**
**Hammer Dorfstrasse 85**
**W-4000 Düsseldorf 1 (DE)**
Erfinder: **Zehrfeld, Jürgen, Dr.**
**Elisabethstrasse 32**
**W-4223 Voerde (DE)**

**EP 0 471 151 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services
(3.10/3.09/3.3.3)

## Beschreibung

Die Erfindung betrifft Bindemittelgemische auf der Basis von Epoxidharzen, die durch Strahlung vernetzbar sind und die anschließend durch thermische Behandlung gehärtet werden.

Derartige Bindemittel haben eine große Bedeutung bei der Herstellung von Photoresists und Schutzlakken.

Aus EP-A 0 194 360 sind entsprechende Bindemittel bekannt, die erhalten werden durch Umsetzung einer Epoxidverbindung mit mehr als 1 Epoxidgruppe pro Molekül, mit einer oder mehreren Carbonsäuren im molaren Verhältnis der Epoxidgruppen zu den Carboxylgruppen von 1 : 0,5 - 0,9 und anschließender Umsetzung des Reaktionsproduktes mit einer oder mehreren ungesättigten Isocyanatocarbamatestern, die durch Umsetzung von Verbindungen mit mindestens zwei Isocyanatgruppen mit hydroxylgruppenhaltigen Acryl-, Methacryl- oder Cyanacrylsäureestern hergestellt werden.

Mit diesen Bindemitteln hergestellte Lacke zeichnen sich durch gute elektrische Werte und durch hervorragende mechanische Eigenschaften des gehärteten Lackfilms aus. Derartige Bindemittel sind dual funktionell, d. h. sie enthalten neben ethylenisch ungesättigten Gruppen Epoxidgruppen. Die daraus hergestellten Lacke werden in einem ersten Härtungsschritt mit aktivierter Strahlung partiell belichtet, und die abgedeckten Flächen werden anschließend mit einem Lösungsmittel entfernt. Anschließend werden in einem zweiten Härtungsschritt die nicht entwickelten Lackschichten thermisch vernetzt. Als Vernetzer dient u. a. Dicyandiamid.

Es ist ein Nachteil dieser Bindemittel, daß sie nicht mit alkalischen, wäßrigen Medien entwickelbar und somit dieser umweltfreundlicheren Technologie nicht zugänglich sind.

Es ist daher die Aufgabe der Erfindung, ein strahlungshärtbares Bindemittelsystem bereitzustellen, das ähnliche gute mechanische und elektrische Eigenschaften aufweist wie das oben geschilderte, das aber darüberhinaus sowohl mit organischen Lösungsmitteln als auch mit alkalischen, wäßrigen Lösungen entwickelbar ist.

Die Lösung der Aufgabe erfolgt durch Bindemittelgemische gemäß der Ansprüche 1 bis 5.

Es wurde gefunden, daß durch Kombination eines an sich bekannten Bindemittels mit einer speziellen Härterkomponente dieses Zeil erreicht werden kann.

Komponente A ist ein Produkt, das erhalten wird durch Umsetzung einer Epoxidverbindung mit mehr als 1 Epoxidgruppe pro Molekül, mit einer oder mehreren Carbonsäuren im molaren Verhältnis der Epoxidgruppen zu den Carboxylgruppen von 1 : 0,5 - 0,9 und anschließender Umsetzung des Reaktionsproduktes mit einer oder mehreren ungesättigten Isocyanatocarbamatestern, die durch Umsetzung von Verbindungen mit mindestens zwei Isocyanatgruppen mit hydroxylgruppenhaltigen Acryl-, Methacryl- oder Cyanacrylsäureestern hergestellt werden.

Derartige Bindemittel sind aus EP-A 0 194 360 bekannt.

Die Härterkomponente B ist ein Produkt, das erhalten wird durch Umsetzung einer Epoxidverbindung mit mehr als 1 Epoxidgruppe pro Molekül, mit einer oder mehreren olefinisch ungesättigten Carbonsäuren im molaren Verhältnis der Epoxidgruppen zu den Carboxylgruppen von 1 : $\geqq$ 1 und anschließender Umsetzung des Reaktionsproduktes mit einer oder mehreren mehrbasischen Carbonsäure(n) oder deren Anhydrid(en).

Die beiden Komponenten können im Gewichtsverhältnis von 3 : 1 bis 1 : 3 mit einander kombiniert werden. In jedem Fall wird ein Bindemittelgemisch erhalten, das auch ohne Stabilisierungsmittel ausgezeichnet gut lagerfähig ist, das mit aktinischem Licht vernetzt werden kann, wobei dieses vernetzte Produkt thermisch nachgehärtet werden kann. Dabei entsteht ein Endprodukt mit guten elektrischen und mechanischen Eigenschaften und insbesondere guter Haftung auf Kunststoffen, Glas, Holz und Holzwerkstoffen, insbesondere auf Metallen.

Trotz der guten Lagerstabilität sind die erfindungsgemäßen Bindemittelgemische so reaktiv, daß sie auch ohne zusätzliche strahlenhärtende Verbindungen eine ausreichende Vernetzungsgeschwindigkeit besitzen, darüber hinaus nicht nur durch Elektronenstrahlen, sondern auch durch UV-Strahlung zur Vernetzung angeregt werden, und daß sie ohne Unterwanderungsvernetzung zu einer klebfreien Oberfläche reagieren.

Bei partieller Belichtung lassen sich überraschenderweise die nicht belichteten Stellen sowohl mit organischen Lösungsmitteln als auch mit alkalischen, wäßrigen Lösungen und mit Mischungen aus wäßrigen und organischen Lösungsmitteln lösen. Entsprechend belichtete Filme des erfindungsgemäßen Bindemittelgemisches lassen sich somit mit allen derzeit in der Resisttechnik üblichen Entwicklungs- oder Ätzverfahren entwickeln.

Zudem führen die erfindungsgemäßen Bindemittel zu Filmen mit sehr hohem Glanz, sehr guten und konstanten mechanischen Eigenschaften und sehr hohen Beständigkeiten gegenüber Chemikalien, da alle Komponenten ungesättigte, strahlungshärtbare Gruppen enthalten, die nach der Belichtung fest in das

Polymernetzwerk eingebunden werden und somit bei der Entwicklung mit Lösungsmitteln keine Quellung des Films und Herauslösen unvernetzbarer Anteile erfolgt, was zu Glanzverlusten und über Änderungen der stöchiometrischen Verhältnisse zur Verschlechterung der mechanischen Eigenschaften und der Beständigkeit führt.

Auch das erfindungsgemäße strahlungshärtbare Bindemittelgemisch zeichnet sich besonders dadurch aus, daß die durch aktinische Strahlung induzierte Polymerisationsrekation nicht unter den nicht belichteten Stellen forgesetzt wird, d.h. es tritt keine Unterwanderungsvernetzung auf. Die unpolymerisierten Anteile des Harzes werden anschließend mit einem Lösungsmittel oder mit einer alkalischen, wäßrigen Lösung entfernt.

Die bei der Entwicklung herausgelösten unbelichteten Anteile lassen sich durch Vernetzungsreaktionen und Ausflockungen infolge von Salzbildungsreaktionen leicht und umweltfreundlich entsorgen.

Nach vollzogenem Ätzprozeß kann der stehengebliebene Lack auf den Leiterbahnen durch thermische Nachhärtung in einen mechanisch dauerhaften, chemisch beständigen und thermisch und elektrisch hochwertigen Schutzlack überführt werden. Besonders vorteilhaft ist die gute Haftfestigkeit auf allen Druckträgern, was sich besonders beim Lötprozeß zeigt, insbesondere beim Druck auf Glanzzinn bzw. Blei/Zinn.

Besondere Erfindungsmerkmale sind außerdem die sehr gute Überdruck- bzw. Überlackierbarkeit und die Haftfestigkeit nachfolgender Drucke, z.B. Kennzeichnungsdrucke. Herausragendes Erfindungsmerkmal des strahlungsvernetzbaren Bindemittelgemisches ist eine besonders gute Durchhärtung, auch in den Tälern zwischen sehr hohen Leiterzügen und ein besonders günstiges Elastizitätsverhalten, z.B. bei Temperaturwechselbelastung. Aus den strahlungsvernetzbaren Bindemittelgemischen lassen sich daher wärmebeständige Abdecklacke als Lötstoplacke herstellen, mit denen ausgewählte Flächen einer Leiterplatte festhaftend abgedeckt werden, damit sich bei dem später folgenden Lötvorgang kein Lötzinn absetzt. Komplett-Lötungen, bei denen viele Lötverbindungen in einem Arbeitsgang hergestellt werden, sind damit problemlos möglich.

Aufgrund des Reaktionsverhaltens der erfindungsgemäßen Bindemittelgemische und ihrer ausgezeichneten mechanischen und elektrischen Eigenschaften nach der Härtung eignen sie sich hervorragend für die Herstellung von Lötstop- und Schutzlacken für Multilayer und gedruckte Schaltungen sowie als Gießmassen für die Elektronik und Elektrotechnik.

Als Ausgangs-Epoxidharze für die Bindemittelkomponenten A und B eignen sich prinzipiell alle Verbindungen, die mehr als 1 Epoxidgruppe pro Molekül enthalten. Sie werden erhalten entweder durch Umsetzung von Polyphenolen bzw. Polyalkoholen mit Epichlorhydrin z.B. nach den US-Patenten 24 67 171, 25 38 072, 25 58 959 sowie 26 94 694 oder durch Umsetzung von mehrfach ungesättigten Verbindungen mit organischen Persäuren, wie sie unter anderem in den US-Patenten 28 53 498, 28 53 499, 28 29 135 beschrieben wird.

Vorteilhaft sind die Umsetzungsprodukte von Bisphenol A mit Epichlorhydrin in alkalischem Medium sowie die Polyglycidyläther von Resorcin, Butandiol, Hexandiol, Glycerin, Trimethylolpropan und Neopentylglykol. Bevorzugte Vertreter der durch Persäuren epoxidierten mehrfach ungesättigten Verbindungen sind epoxidierte Cycloolefine wie z.B. 3,4-Diepoxi-6-methyl-tetrahydrobenzyl-3',4'- diepoxi-6'-methyl-tetrahydrobenzoat, Vinylcyclohexendioxid u. a.,sowie die Diglycidylester auf Basis von Anhydriden, wie Hexahydrophthalsäure- oder Methylnadicsäure-anhydrid.

Insbesondere bevorzugt sind alle Novolake, deren phenolische Hydroxylgruppen mit Glycidylresten veräthert sind, z.B. Bisphenol-A- oder Bisphenol-F-Novolak-Epoxidharze oder die entsprechenden Ortho- oder Para-Kresol-Epoxidharz-Novolaksysteme bzw. entsprechende chlorierte oder bromierte Produkte für schwerentflammbare Einstellungen. Die hierfür erforderlichen Novolake können hergestellt werden z.B. aus Basis von Phenol, ortho-, metha-, oder para-Kresol, Dimethylphenolen, höheralkylierten Phenolen, z.B. Nonylphenol, tert.-Butylphenol, oder halogenierten Phenolen sowie Polyphenolen, z.B. Resorcin, Hydrochinon, Brenzkatechin, Pyrogallol, Phloroglucin oder auch Trihydroxyphenylmethan oder Tetrahydroxyphenylethan durch Umsetzung mit Aldehyden, vorzugsweise Formaldehyd unter saurer Katalyse. Diese Epoxidverbindungen entsprechen der allgemeinen Formel I

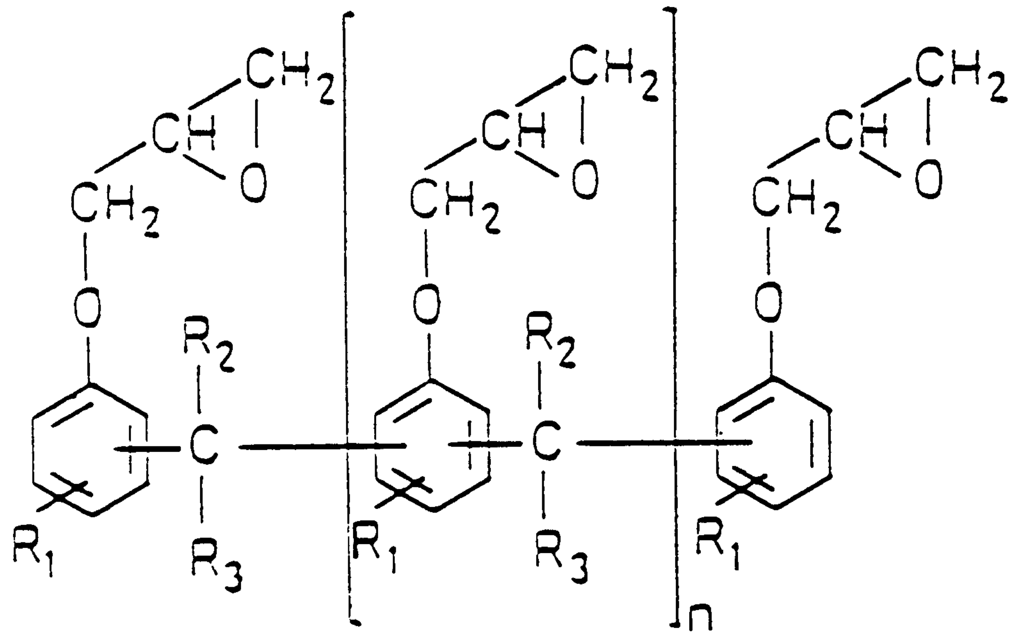

(I)

wobei
$R_1$ = H-, $CH_3$-, $C_2H_5$-, $C_4H_9$-, Br-, Cl-
$R_2$ = H-, $CH_3$-
$R_1$ = H-, $CH_3$- ist.

Diesen Epoxidharzen können vor der Umsetzung zum Zwecke einer besseren Viskositätseinstellung vor der Umsetzung mit Carbonsäuren Zusätze von mono- und bifunktionellen Epoxidverbindungen sog. Reaktivverdünnern, zugegeben werden.

Zur Herstellung der Komponente A können als Carbonsäuren alle gängigen Monocarbonsäuren verwendet werden. Beispiele hierfür sind die unverzweigten Monocarbonsäuren, wie die Ameisensäure, Essigsäure, Propionsäure, Milchsäure, Stearinsäure sowie auch verzweigte Carbonsäuren oder auch aromatische Carbonsäuren wie Benzoesäure oder Phenylessigsäure und bevorzugt ungesättigte Carbonsäuren vom Typ der Acrylsäure, Methacrylsäure oder Zimtsäure die eine Erhöhung der Netzwerkdichte bewirken.

Die Umsetzung erfolgt in an sich bekannter Weise durch Zusammenrühren der flüssigen oder in Lösung vorliegenden Reaktanten bei erhöhter Temperatur. Wichtig für die Eigenschaften des Endproduktes ist das molare Verhältnis der Epoxidgruppen zu den Carboxylgruppen, das in jedem Falle größer als 1 sein muß, so daß freie Epoxidgruppen vorliegen, die nach der strahlungsbedingten Vernetzung eine thermische Härtung ermöglichen. Im allgemeinen liegt das Verhältnis zwischen 1 : 0,5 - 0,9.

Die Umsetzung der vorgenannten Epoxidharzsysteme mit den Monocarbonsäuren führt zu Umsetzungsprodukten, die sich in hervorragender Weise für eine weitere Umsetzung mit ungesättigten Isocyanatocarbamatestern eignen. Diese Isocyanatocarbamatester können hergestellt werden durch Umsetzung von Polyisocyanaten, z.B. 2,4- oder 2,6-Toluylendiisocyanaten bzw. auch deren Isomeren-Mischungen (Handelsbezeichnung z.B. "Desmodur T 80"), Methylendiphenyldiisocyanat, 1,6-Hexamethylendiisocyanat, Hexandiisocyanat, 1,5-Naphthylendiisocyanat, Isophorondiisocyanat, Trimethylhexamethylendiisocyanat, 4,4', 4",-Triphenylmethan-Triisocyanat oder anderen bekannten Polyisocyanaten mit hydroxylgruppenhaltigen ungesättigten Estern.

Als hydroxylgruppenhaltige ungesättigte Ester eignen sich insbesondere Hydroxy-ethyl- oder -propylacrylat oder die entsprechenden Hydroxy-methacrylate oder Hydroxy- cyanacrylate, auch Butan- oder Hexandiolmonoacrylate.

Umgesetzt wird in an sich bekannter Weise im einfach molaren Verhältnis. Die ungesättigten Isocyanatocarbamatester entsprechen der allgemeinen Formel II:

$$OCN-R_1-NH-\overset{\overset{\displaystyle O}{\|}}{C}-O-R_2-O-\overset{\overset{\displaystyle O}{\|}}{C}-\overset{\overset{\displaystyle R_3}{|}}{C}=CH_2 \quad \text{, wobei} \qquad (II)$$

| | | | |
|---|---|---|---|
| $R_1$ = | Toluylen(2,4; 2,6)-, | $R_2$ = | $C_2H_4$-, $C_3H_6$-, |
| | 4,4'-Diphenylmethan-, | | $C_4H_8$-, |
| | 1,6-Hexamethylen-, | | |
| | 1,5-Naphthylen-, | $R_3$ = | H-, $CH_3$-, CN-, |
| | Isophoron- | | $C_2H_5$-, |
| | Trimethylhexamethylen-, | | $C_3H_7$- ist. |

Die Umsetzung der carbonsäure-modifizierten Epoxidharze mit den ungesättigten Isocyanatocarbamatestern erfolgt ebenfalls in an sich bekannter Weise, wobei die eingesetzten Mengen so gewählt werden, daß die molaren Verhältnissse der vorhandenen Hydroxylgruppen zu den Isocyanatgruppen im Bereich von 1 : 0,8 bis 1 : 1 liegen. Diese Umsetzung führt zu einer sehr lagerstabilen und dabei gegenüber aktinischer Strahlung hochreaktiven Bindemittel-Komponente. Das durchschnittliche Molekulargewicht kann wahlweise zwischen 500 und 10.000, je nach den geforderten Eigenschaften, eingestellt werden.

Für die Herstellung der Komponente B werden die Epoxidverbindungen in an sich bekannter Weise mit einer oder mehreren olefinisch ungesättigten Carbonsäure(n) umgesetzt.

Beispiele für derartige ungesättigte Carbonsäuren sind rein aliphatische Carbonsäuren wie Acryl-, Methacryl- oder Crotonsäure, aber auch Teilester ungesättigter Dicarbonsäuren wie z. B. Fumarsäuremonoalkylester sowie aromatisch oder heterocyclisch substituierte ungesättigte Carbonsäuren wie z. B. Zimtsäure oder Furylacrylsäure. Wichtig ist dabei das verwendete molare Verhältnis von Epoxidgruppen zu Carboxylgruppen, das bei der Komponente B so gewählt wird, daß mindestens die den Epoxidgruppen entsprechende stöchiometrische Menge an Carboxylgruppen eingesetzt wird. Es empfiehlt sich ein leichter Überschuß an ungesättigter Carbonsäure, um zu gewährleisten, daß die Epoxidgruppen möglichst vollständig umgesetzt werden. Bevorzugt wird ein molares Verhältnis von Epoxidgruppen zu den Carboxylgruppen von 1 : 1,02 - 1,03.

Die Hydroxylgruppen der dabei entstehenden Produkte werden nun in ebenfalls an sich bekannter Weise mit einer oder mehreren mehrbasischen Carbonsäure(n) oder deren Anhydrid(en) umgesetzt. Beispiele für derartige Polycarbonsäuren oder Anhydride sind Phthal-, Trimellith-, Pyromellith-, Malein-, Bernstein-, Adipin- oder Hexahydrophthalsäure sowie deren Anhydride.

Die Komponenten A und B sind unter Ausschluß von Strahlung lagerfähig.

Die Herstellung des erfindungsgemäßen Bindemittelgemisches erfolgt durch einfaches Vermischen der beiden Komponenten unter Ausschluß von energiereicher Strahlung d. h., entweder in einem abgedunkelten Raum oder in einen speziellen Rot- oder Gelblichtraum. Dabei kann das Gewichtsverhältnis der beiden Komponenten im Bereich von 3 : 1 bis 1 : 3 liegen. Das Bindemittelgemisch ist über mehrere Wochen lagerfähig, was erhebliche Vorteile in der Anwendung hat.

Darüberhinaus können die erfindungsgemäßen Bindmittelgemische weitere, in derartigen Systeme übliche Zusätze wie Photopolymerisationsinitiatoren, Katalysatoren für die thermische Nachhärtung, Verdünnungsmittel, Weichmacher, Stabilisatoren, Entschäumungs- oder Glättmittel, Pigmente oder Füllstoffe enthalten.

Insbesondere zur gezielten Einstellung der UV-Reaktivität können die allgemein üblichen Photoinitiatoren, z.B. Benzoine, oder Benzildimethylketal, Benzoinether, Benzophenone, Dithiobis(benzothialzol), Oxophosphorane und Kombinationen von aromatischen Sulfochloriden mit Disulfiden oder Xanthogenaten, zur Erhöhung der Polymerisationsgeschwindigkeit eingesetzt werden. Aushärtungszeiten von unter 30 s sind problemlos einstellbar, wobei klebfreie Filme mit hohem mechanischem, thermischem und elektrischem Eigenschaftsniveau und guter Chemikalienbeständigkeit erreicht werden.

Die strahlungsvernetzbaren Bindemittelgemische werden vorzugsweise durch Zusatz von Katalysatoren für die thermische Nachhärtung zur Herstellung von I- oder II-Komponenten-Beschichtungssystemen weiter

formuliert. Als latente Katalysatoren für die thermische Nachhärtung der Epoxidgruppen mit den Carboxylgruppen eignen sich z.B. Imidazole, tertiäre Amine oder $BF_3$- oder auch $BCl_3$-Aminkomplexe.

Besonders vorteilhaft sind latente Katalysatoren, die sowohl bei der Vernetzung als Photoinitiatoren als auch bei der thermischen Härtung als Härtungskatalysatoren wirken, insbesondere Verbindungen vom Typ des Michler's Ketons, die der allgemeinen Formel III entsprechen:

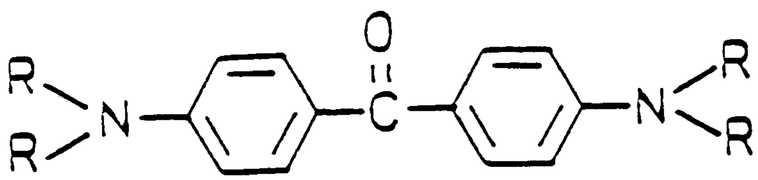

(III)

wobei R = $CH_3$- oder $C_2H_5$- ist.

Erreicht werden sehr kurze Aushärtungszeiten von 20 min bei Temperaturen von 120 bis 230 °C, je nachdem, welcher Glasumwandlungspunkt für das ausgehärtete Beschichtungssystem erreicht werden soll.

**Beispiele**

Beispiel 1

Umsetzung von Epoxidharzen mit Carbonsäure

1.1 In einem 2-1-Dreihalskolben mit Rührwerk, Rückflußkühler und Thermometer werden 1 Mol (= 619 g) eines Phenol-Novolak- Epoxidharzes mit einer durchschnittlichen Funktionalität von 3,5 vorgelegt. Hierzu werden 200 g Xylol gegeben und die Mischung auf etwa 80 °C erhitzt. Bei dieser Temperatur werden innerhalb von 15 - 30 min 1,75 Mol (= 129,5 g) Propionsäure zugetropft und die Mischung 3 h bei 80 °C gerührt. Danach wird das Xylol abdestilliert und die verbleibende Harzmasse in Ethylglykolacetat aufgenommen. Für eine 70%ige Harzlösung in Ethylglykolacetat werden folgende charakteristische Spezifikationsdaten erhalten:

| | |
|---|---|
| Viskosität / 25 ° C: | 2400 - 2500 mPa.s |
| nD / 25 ° C: | 1,5200 - 1,5300 |
| Säurezahl: | 1 mg/g |
| Epoxidzahl: | 8 - 10 % |

1.2 In einem 2-1-Dreihalskolben mit Rührwerk, Rückflußkühler und Thermometer werden 1 Mol (= 619 g) eines Phenol-Novolak-Epoxidharzes mit einer durchschnittlichen Funktionalität von 3,5 vorgelegt. Hierzu werden 200 g Xylol gegeben und die Mischung auf etwa 80 °C erhitzt. Bei dieser Temperatur werden innerhalb von 15 - 30 min 1,2 Mol (= 120 g) 1,2-Milchsäure (90%ig) zugetropft und die Mischung bei 80 °C 2 h gerührt. Danach wird das Xylol abdestilliert und die verbleibende Harzmasse in Ethylglykolacetat aufgenommen. Für eine 70%ige Harzlösung in Ethylglykolacetat werden folgende charakteristische Spezifikationsdaten erhalten:

| | |
|---|---|
| Viskosität /25 °C | 4000 - 6000 mPa.s |
| nD / 25 °C: | 1,5200 - 1,5300 |
| Säurezahl: | 1 mg/g |
| Epoxidzahl: | 8 - 10 % |

Beispiel 2

Umsetzen von Polyisocyanaten mit hydroxylgruppenhaltigen, ungesättigten Verbindungen

In einem 2-1-Dreihalskolben mit Rührwerk, Rückflußkühler und Thermometer werden 1 Mol (= 174 g) Toluylen-(2,4 und 2,6) diisocyanat-Isomerengemisch (Desmodur T 80) vorgelegt. Hierzu werden 130 g

Ethylglykolacetat als Lösungsmittel zugegeben. Dieser Lösung werden innerhalb von 30 min portionsweise 1 Mol Hydroxyethylacrylat (=116 g) zugegeben. Die Mischung erwärmt sich hierbei langsam auf etwa 80 °C. Bei dieser Temperatur läßt man noch etwa 1 h nachreagieren. Zur Stabilisierung kann man 0,1 % eines Stabilisators, z.B. Hydrochinon, zugeben. Erhalten werden 420 g einer 70%igen Reaktionsmischung in Ethylglykolacetat.

Beispiel 3

Umsetzung von hydroxylgruppenhaltigen Epoxidharzen nach Beispiel 1 mit isocyanatgruppenhaltigen, ungesättigten Verbindungen entsprechend Beispiel 2

3.1 In einem 2-1-Dreihalskolben mit Rührwerk, Rückflußkühler und Thermometer werden 887 g eines Reaktionsproduktes gemäß Beispiel 2 vorgelegt und auf 60 °C erwärmt. Bei dieser Temperatur werden portionsweise innerhalb von 1 h 860 g eines Umsetzungsproduktes, wie in Beispiel 1.1 beschrieben, zugegeben. Die Reaktionsmischung läßt man noch etwa 1 h bei 60 °C nachreagieren. Danach wird abgekühlt. Erhalten wird eine Reaktionsmasse mit folgenden Eigenschaften:

| | |
|---|---|
| Viskosität / 25 °C: | 12 000 - 15 000 mPa·s |
| nD /25 °C: | 1,5100 |
| Festkörpergehalt: | 70 % |
| Lagerstabilität: | 6 Monate bei dunkler Lagerung |

3.2 In einem 2-1-Dreihalskolben mit Rührwerk, Rückflußkühler und Thermometer werden 887 g eines Reaktionsproduktes gemäß Beispiel 2 vorgelegt und auf 60 °C erwärmt. Bei dieser Temperatur werden portionsweise innerhalb von 1 h 860 g eines Umsetzungsproduktes, wie in Beispiel 1.2 beschrieben, zugegeben. Die Reaktionsmischung läßt man noch etwa 1 h bei 60 °C nachreagieren. Danach wird abgekühlt. Erhalten wird eine Reaktionsmasse mit folgenden Eigenschaften:

| | |
|---|---|
| Viskosität / 25 °C: | etwa 15 000 - 20 000 |
| mPa.s nD /25 °C: | 1,5100 - 1,5200 |
| Festkörpergehalt: | ca. 70 % |
| Lagerstabilität: | 6 Monate bei dunkler Lagerung |

Beispiel 4

Umsetzung von Epoxidharzen mit Acrylsäure und anschließender Reaktion mit Bernsteinsäureanhydrid

In einem 2 1-Dreihalskolben mit Rührwerk, Rückflußkühler und Thermometer werden 615 g eines Bisphenol-A-Novolak-Epoxidharzes, das aus Bisphenol-A und Formalin und anschließender Umsetzung mit Epichlorhydrin erhalten wird, mit einer durchschnittlichen Funktionalität von 8, einem Epoxidäquivalent von 205 und einer Viskosität von 1.240 mPa.s bei 150 °C vorgelegt. Hierzu werden 484 g Methoxypropylacetat gegeben und die Mischung auf 80 °C erhitzt.

Bei dieser Temperatur werden 219 g Acrylsäure zugegeben und die Mischung ca. 60 h bei 80 °C gerührt, bis die Säurezahl auf < 3 abgesunken ist.

Anschließend werden zu der Reaktionsmischung 300 g Bernsteinsäureanhydrid hinzugefügt und ca. 20 h bei 75 °C gerührt.

Das Produkt hat eine Viskosität von 43.200 mPa.s bei 25 °C, Brechungsindex $n_D25$ 1,5030 und einen Festkörpergehalt von 70 %.

Beispiel 5

Umsetzung eines Epoxidharzes mit Acrylsäure und Phthalsäureanhydrid

Beispiel 4 wurde wiederholt. Anstelle des Bernsteinsäureanhydrids wurden 444 g Phthalsäureanhydrid verwendet. Die Lösung wurde nach der Umsetzung mit Methoxypropylacetat auf einen Festkörpergehalt

von 70 % eingestellt.

Produktdaten

| | |
|---|---|
| Viskosität<br>Brechungsindex $n_D25$ | 19.350 mPa.s bei 25 °C<br>1,5110 |

Beispiel 6

Umsetzung eines Epoxidharzes mit Acrylsäure und Hexahydrophthalsäureanhydrid

Beispiel 4 wurde wiederholt. Anstelle des Bernsteinsäureanhydrids wurden 462 g Hexahydrophthalsäureanhydrid verwendet. Die Lösung wurde nach der Umsetzung mit Methoxypropylacetat auf einen Festkörpergehalt von 70 % eingestellt.

Produktdaten

| | |
|---|---|
| Viskosität<br>Brechungsindex $n_D25$ | 20.950 mPa.s bei 25 °C<br>1,5010 |

Beispiel 7

Umsetzung eines Epoxidharzes mit Acrylsäure und Bernsteinsäureanhydrid

Beispiel 4 wurde wiederholt. Anstelle des Bisphenol-A-Novolak-Epoxidharzes wurden 630 g eines O-Kresol-Novolak-Epoxidharzes mit einer durchschnittlichen Funktionalität von 6, einem Epoxidäquivalent von 210 und einer Viskosität von 1.105 mPa.s bei 150 °C verwendet.

Produktdaten

| | |
|---|---|
| Viskosität<br>Brechungsindex $n_D25$ | 20.730 mPa.s bei 25 °C<br>1,5300 |

Beispiel 8

Umsetzung eines Epoxidharzes mit Acrylsäure und Bernsteinsäureanhydrid

Beispiel 4 wurde wiederholt. Anstelle des Bisphenol-A-Novolak-Epoxidharzes wurden 531 g eines Phenol-Novolak-Epoxidharzes mit einer durchschnittlichen Funktionalität von 3,5, einem Epoxidäquivalent von 177 und einer Viskosität von 1.100 mPa.s bei 80 °C verwendet.

Produktdaten

| | |
|---|---|
| Viskosität<br>Brechungsindex $n_D25$ | 5.900 mPa.s bei 25 °C<br>1,5000 |

Herstellung der Lackkomponenten:

Aus den Produkten des Beispiels 3 wurden in Kombination mit den Produkten aus den Beispielen 4 bis 8 nach den in der Lackindustrie üblichen Methoden unter Verwendung von Pigmenten, Füllstoffen, Verdünnungsmitteln und Additiven Lacke entsprechend den Beispielen 9 bis 13 hergestellt.

Als Vergleichsbeispiel dient Beispiel 14.

Tabelle 1

| Komp. A | Bsp. 9 | Bsp. 10 | Bsp. 11 | Bsp. 12 | Bsp. 13 | Bsp. 14 |
|---|---|---|---|---|---|---|
| Produkt aus Bsp. 3.1 | | | 40,0 | 28,0 | | |
| Produkt aus Bsp. 3.2 | 40,0 | 28,0 | | | 48,0 | 77,0 |
| Benzildimethylketal | 3,5 | 3,5 | 3,5 | 3,5 | 3,5 | 3,5 |
| Phthalocyaningrün | 0,2 | 0,2 | 0,2 | 0,2 | 0,2 | 0,2 |
| Füllstoff | 6,3 | 3,3 | 6,3 | 3,3 | 8,3 | 9,3 |
| | 50,0 | 35,0 | 50,0 | 35,0 | 60,0 | 90,0 |
| Komp. B | | | | | | |
| Produkt aus Bsp. 4 | 35,0 | | | | | |
| Produkt aus Bsp. 5 | | 45,0 | | | | |
| Produkt aus Bsp. 6 | | | 35,0 | | | |
| Produkt aus Bsp. 7 | | | | 44,0 | | |
| Produkt aus Bsp. 8 | | | | | 27,0 | |
| Verdünnungsmittel | 8,0 | 9,0 | 8,0 | 10,0 | 6,0 | 3,2 |
| Verlaufmittel | 0,5 | 0,5 | 0,5 | 0,5 | 0,5 | 0,5 |
| Phenylimidazol | 0,1 | 0,1 | 0,1 | 0,1 | 0,1 | |
| Füllstoff | 6,4 | 10,4 | 6,4 | 10,4 | 6,4 | 5,0 |
| Dicyandiamid | | | | | | 1,3 |
| | 50,0 | 65,0 | 50,0 | 65,0 | 40,0 | 10,0 |

Lacktechnische Ausprüfung:

Die Komponenten A und B aus den Beispielen 9 bis 14 werden gewichtsmäßig entsprechend der Tabelle 1 gemischt und auf eine kupferkaschierte Leiterplatte mit einer Trockenschichtstärke von 30 µm aufgebracht und in einen Umlufttrockenofen 30 min. bei 80 °C getrocknet.

Anschließend wird mit einer Schablone abgedeckt und partiell mit UV-Licht belichtet. Die Leiterplatten werden dann entwickelt. Zur Anwendung als Lötstoplack werden die erhaltenen Leiterplatten anschließend einer thermischen Nachbehandlung unterzogen. Die Nachhärtung wird innerhalb von 20 bis 30 min. bei Temperaturen von 120 bis 150 °C durchgeführt, je nachdem, welcher Glasumwandlungspunkt für das ausgehärtete Beschichtungsmaterial gewünscht wird. Danach können die Lötprozesse erfolgen.

Tabelle 2 zeigt die Ausführungsergebnisse:

**Tabelle 2**

| Beispiel | 9 | 10 | 11 | 12 | 13 | 14 |
|---|---|---|---|---|---|---|
| Klebrigkeit nach der 1. Trocknung | keine | keine | keine | keine | keine | keine |
| Entwickelbarkeit in 1%iger wässriger Sodalösung | + | + | + | + | + | nicht möglich |
| Entwickelbarkeit in Diethylenglycolmonobutylether | + | + | + | + | + | + |
| Lötbadtest 10 s/ 288 °C | erfüllt | erfüllt | erfüllt | erfüllt | erfüllt | erfüllt |
| Haftung | + | + | + | + | + | + |
| Isolationswiderstand nach IPC-SM 840 B [Ω] | $>10^9$ | $>10^9$ | $>10^9$ | $>10^9$ | $>10^9$ | $>10^9$ |

## Patentansprüche

1. Durch Strahlung vernetzbare Bindemittelgemische, **dadurch gekennzeichnet**, daß sie als Komponente A ein Produkt enthalten, das erhalten wird durch Umsetzung einer Epoxidverbindung mit mehr als 1 Epoxidgruppe pro Molekül, mit einer oder mehreren Carbonsäuren im molaren Verhältnis der Epoxidgruppen zu den Carboxylgruppen von 1 : 0,5 - 0,9 und anschließender Umsetzung des Reaktionsproduktes mit einer oder mehreren ungesättigten Isocyanatocarbamatestern, die durch Umsetzung von Verbindungen mit mindestens zwei Isocyanatgruppen mit hydroxylgruppenhaltigen Acryl-, Methacryl- oder Cyanacrylsäureestern hergestellt werden und als Komponente B ein Produkt enthalten, das erhalten wird durch Umsetzung einer Epoxidverbindung mit mehr als 1 Epoxidgruppe pro Molekül, mit einer oder mehreren olefinisch ungesättigten Carbonsäuren im molaren Verhältnis der Epoxidgruppen zu den Carboxylgruppen von 1 : ≧ 1 und anschließender Umsetzung des Reaktionsproduktes mit einer oder mehreren mehrbasischen Carbonsäure(n) oder deren Anhydrid(en), wobei die Komponenten A und B im Gewischtsverhältnis von 3 : 1 bis 1 : 3 vorliegen.

2. Bindemittelgemisch nach Anspruch 1, **dadurch gekennzeichnet**, daß für beide Komponenten die Epoxidharzverbindung ein Novolak ist, dessen phenolische Hydroxylgruppen mit Glycidylgruppen veräthert sind.

3. Bindemittelgemisch nach Anspruch 2, **dadurch gekennzeichnet**, daß die Epoxidharzverbindung Zusätze von mono- oder bifunktionellen Epoxidverbindungen enthält.

4. Bindemittelgemsich nach den Ansprüchen 1 bis 3, **dadurch gekennzeichnet**, daß die Komponente A ein Durchschnittsmolekulargewicht von 500 - 10000 besitzt.

5. Bindemittelgemisch nach den Ansprüchen 1 bis 4, **dadurch gekennzeichnet**, daß zur Herstellung der Komponente A die carbonsäuremodifizierten Epoxidharze und die Isocyanatocarbamatester im molaren Verhältnis der Hydroxylgruppen zu den Isocyanatgruppen von 1 : 0,8 bis 1 : 1 miteinander umgesetzt werden.

## Claims

1. Radiation cross-linkable binder mixtures characterised in that they contain as component A a product obtained by converting an epoxide compound having more than 1 epoxide group per molecule, with one or more carbonic acids in a molecular ratio of epoxide groups to carboxyl grups of 1 : 0.5 - 0.9 and subsequently converting the reaction product with one or more unsaturated isocyanatocarbamate esters, which are manufactured by converting compounds having at least two isocyanate groups with acrylic, methacrylic or cyanacrylic acid esters containing hydroxyl groups and as component B contain a product obtained by converting an epoxide compound having more than 1 epoxide group per molecule, with one or more olefinic unsaturated carbonic acids in a molecular ratio of expoxide groups to carboxyl groups of 1 : > 1 and subsequently converting the reaction product with one or more polybasic carbonic acids or anhydrides thereof, components A and B being present in a weight ratio of 3 : 1 to 1 : 3.

2. Binder mixture according to claim 1, characterised in that for both components the epoxy resin compound is a novolak, whose phenolic hydroxyl groups are etherified with glycidyl groups.

3. Binder mixture according to claim 2, characterised in that the epoxy resin compound contains additives of mono- or bifunctional epoxide compounds.

4. Binder mixture according to claims 1 to 3, characterised in that compound A has a mean molecular weight of 500 - 10000.

5. Binder mixture according to claims 1 to 4, characterised in that for preparing component A the carbonic acid-modified epoxide resin and the isocyanatocarbamate esters are reacted with one another in a molecular ratio of hydroxyl groups to isocyanate groups of 1 : 0.8 to 1 : 1.

## Revendications

1. Mélanges de liants réticulables par irradiation, caractérisés en ce qu'ils contiennent en tant que composant A un produit qui est obtenu par réaction d'un composé époxydique comportant plus de 1 groupe époxy par molécule, avec un ou plusieurs acides carboxyliques dans le rapport molaire des groupes époxy aux groupes carboxyles de 1:0,5-0,9 et réaction subséquente du produit réactionnel avec un ou plusieurs esters isocyanatocarbamiques insaturés oui sont préparés par réaction de composés comportant au moins deux groupes isocyanates avec des esters acryliques, méthacryliques ou cyanacryliques hydroxylés et qu'ils contiennent en tant que composant B un produit oui est obtenu par réaction d'un composé époxydique comportant plus de 1 groupe époxy par molécule, avec un ou plusieurs acides carboxyliques oléfiniquement insaturés dans le rapport molaire des groupes époxy aux groupes carboxyles de 1:≧1 et réaction subséquente du produit réactionnel avec un ou plusieurs polyacides carboxyliques ou son ou leurs anhydrides, les composants A et B étant présents dans le rapport pondéral de 3:1 à 1:3.

2. Mélange de liants selon la revendication 1, caractérisé en ce que, pour les deux composants, le composé à base de résine époxydique est une novolaque dont les groupes hydroxyles phénoliques sont éthérifiés avec des groupes glycidyles.

3. Mélange de liants selon la revendication 2, caractérisé en ce que le composé à base de résine époxydique comporte des additions de composés époxydiques mono- ou difonctionnels.

4. Mélange de liants selon les revendications 1 à 3, caractérisé en ce que le composant A possède une masse moléculaire moyenne de 500-10.000.

5. Mélange de liants selon les revendications 1 à 4, caractérisé en ce que, pour la préparation du composant A, on fait réagir ensemble les résines époxydiques modifiées par des acides carboxyliques et les esters isocyanatocarbamiques dans le rapport molaire des groupes hydroxyles aux groupes isocyanates de 1:0,8 à 1:1